Europäisches Patentamt

European Patent Office

Office européen des brevets

(19)

(11) Publication number: **0 109 194**
**A1**

(12)

# EUROPEAN PATENT APPLICATION

(21) Application number: **83306253.2**

(22) Date of filing: **14.10.83**

(51) Int. Cl.³: **G 11 B 7/12, H 01 S 3/13**

(30) Priority: **14.10.82 JP 181856/82**

(43) Date of publication of application: **23.05.84**
Bulletin 84/21

(84) Designated Contracting States: **DE FR GB NL**

(71) Applicant: **MITSUBISHI DENKI KABUSHIKI KAISHA, 2-3, Marunouchi 2-chome Chiyoda-ku, Tokyo 100 (JP)**

(72) Inventor: **Okada, Kazuo c/o Mitsubishi Denki K.K., Denshishohinkaihatsukenkyusho 1, Babazusho Nagaokakyo-shi Kyoto-fu (JP)**
Inventor: **Shikama, Shinsuke c/o Mitsubishi Denki K.K., Denshishohinkaihatsukenkyusho 1, Babazusho Nagaokakyo-shi Kyoto-fu (JP)**
Inventor: **Egashira, Nobumasa c/o Mitsubishi Denki K.K., Denshishohinkaihatsukenkyusho 1, Babazusho Nagaokakyo-shi Kyoto-fu (JP)**
Inventor: **Hashimoto, Akira c/o Mitsubishi Denki K.K., Denshishohinkaihatsukenkyusho 1, Babazusho Nagaokakyo-shi Kyoto-fu (JP)**

(74) Representative: **Wright, Peter David John et al, R.G.C. Jenkins & Co. 12-15, Fetter Lane, London EC4A 1PL (GB)**

(54) Optical information reproducing apparatus.

(57) An optical information reproducing apparatus for optically reproducing a signal recorded on a disc which comprises a light source (1) of a semiconductor laser having a single longitudinal mode characteristic, a recording disc (8) having an information track of an optically readable structure, a collimating lens (2) for condensing a linearly polarized light beam from the light source to apply the same to the recording disc, an objective lens (7) for condensing the reflected light beam, a polarization beam splitter (4) for separating the reflected light beam, a light detector (11) for detecting the separated light beam, and a feed back means such as a phase plate (5) involving a wavelength deviation by a predetermined amount from the 1/4 wavelength, or a 1/4 wavelength phase plate disposed to be inclined by more than a predetermined angle about the light axis of the light source, or the like, for feeding back a portion of the reflected light beam exceeding a predetermined amount to the light source.

TITLE OF THE INVENTION

Optical Information Reproducing Apparatus

BACKGROUND OF THE INVENTION

Field of the Invention

The present invention relates to an optical information reproducing apparatus for optically reproducing information concerning a sound, video or the like recorded in the form of uneveness on a recording media and, more specifically, relates to such an optical information reproducing apparatus using a secmiconductor laser as a light source.

Description of the Prior Art

Conventionally, an optical information reproducing apparatus has been used for reproducing information of a high density and a large capacity recorded on a disc in an audio PCM disc player, a video disc player and the like. Reproduction of a signal from a disc is perfomed by applying a laser beam onto a disc surface having the information recorded in the form of a group of pits and by detecting the light beam reflected from the disc surface. More specifically, a beam from a laser source is caused to impinge upon the disc surface through an optical path of such as a lens, a mirror and the like and the beam applied to the portion having no pits on the disc surface is reflected therefrom to be transferred through the light path in an approximate reverse direction to the incident light beam, whereas the beam applied to the portion having pits on the disc surface is diffracted through passage of the beam through pits as narrow as the wavelength of the beam, whereby the reflected light beam is about to diverge.  Then, the incident light and reflected light are separated by the use of a beam splitter and the amount of the reflected light is detected by means of a photodetector, for example, to see the presence or absence of the pits, whereby an electrically reproduced signal can be obtained as a function of the presence or absence of the pits.

In order to make small-sized such an optical information reproducing apparatus, a semiconductor laser has been employed as a light source.  In particular, a consideration has been given in such an optical information reproducing apparatus to employ a semiconductor laser of a single longitudinal mode characteristic so that a laser beam of a stable single wavelength may be utilized.

However, in the case where a semiconductor laser of a single longitudinal mode characteristic is employed as a light source, a problem is involved that a signal to noise ratio of a reproduced signal is degraded.  This is caused by the fact that a reflected light beam to be separated by a beam splitter is slightly leaked, say up to 1 %, whereby the reflected light beam is fed into the semiconductor laser of a light source.  Feedback of even a small amount of the light beam to the semiconductor laser causes interference of the fedback light beam with the light beam inside the semiconductor laser, thereby to produce a disturbance in an oscillation mode of the semiconductor laser and hence reproduces a large noise. Thus, generation by the light source itself of a noise degrades a signal to noise ratio of the reproduced signal.

An optical information reproducing apparatus employing a semiconductor laser usually comprises a beam splitter for fully separating a reflected light beam from the disc surface, which includes a polarization beam splitter and a 1/4 wave length phase plate, as precisely adjusted, whereby the reflected light beam is fully separated. However, since a disc material has an optical anisotropy, the reflected light beam from the disc surface cannot be necessarily caused to undergo linear polarization and a small amount of the same passes through the polarization beam splitter to be leaked, with the result that the same could not be prevented from impinging upon the semicondcutor laser.

SUMMARY OF THE INVENTION

Accordingly, a principal object of the present invention is to provide an optical information reproducing apparatus, wherein a signal to noise ratio of a reproduced signal to a noise occurring through feedback of a reflected light beam is improved.

Briefly described, the present invention comprises an optical information reproducing apparatus for optically reproducing a signal recorded on a disc, which comprises a light source of a semiconductor laser having a single longitudinal mode characteristic, a recording disc having an information track of an optically readable structure, a lens for condensing a laser beam from the light source for applying the same onto the recording disc and for condensing the reflected light beam from the recording disc, separating/feeding back means for separating the reflected light beam as condensed by the lens from the laser light beam transmitted from the light source to the lens and for feeding back an amount of the reflected light beam exceeding a predetermined amount to the light source, and a light detector for detecting the reflected light beam separated by the separating/feeding means for providing a reproduced signal.

In a preferred embodiment of the present invention, the above described separating/feeding back means comprises a combination of a polarization beam splitter and a phase plate, adapted such that an amount of the reflected light beam exceeding a predetermined amount may be fed back to the light source by shifting the phase of the above described phase plate by a predetermined amount from a 1/4 wavelength.

In another preferred embodiment of the present invention, the above described separating/feeding back means comprises

- 5 -

a combination of a polarization beam splitter and a 1/4 wavelength phase plate, wherein the above described phase plate is disposed to be inclined abount the light axis of the light source with respect to the linearly polarized light beam from the above described light source for more than a predetermined angle, whereby an amount of the above described reflected light beam exceeding a predetermined amount is fed back to the above described light source.

These objects and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a view showing the structural principle of one embodiment of the present invention;

Fig. 2 is a view showing the structure of another embodiment of the present invention; and

Fig. 3 is a graph showing the characteristic of a signal to noise ratio in accordance with the embodiment of the present invention.

DESCRIPTION OF THE PREFERRED EMBODIMENTS

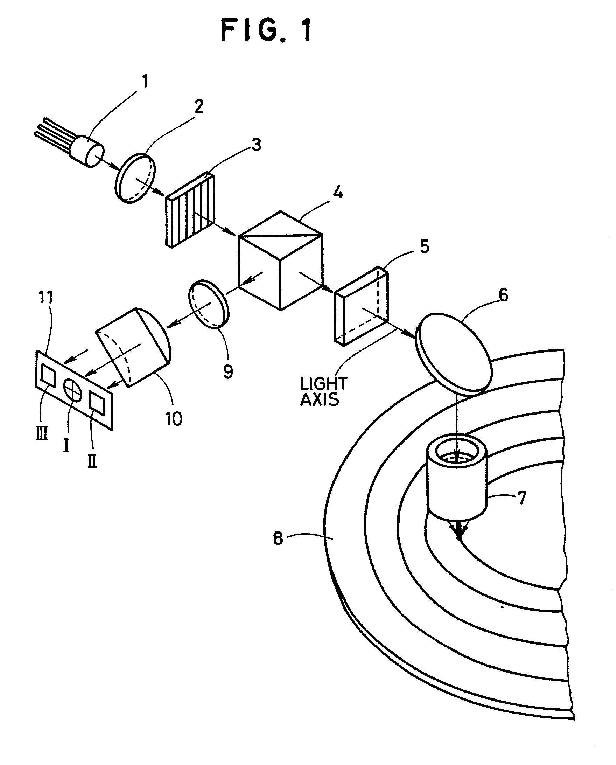

Now referring to Fig. 1, description will be made of one embodiment of an optical information reproducing apparatus in accordane with the present invention. A semiconductor laser 1 of a single longitudinal mode characteristic is provided as a light source and a collimating lens 2 is provided on the light path of the above described semiconductor laser 1, such that a linearly polarized light beam from the above described semiconductor laser 1 is made to be a parallel flux by means of the above described collimating lens 2, A diffraction grating 3 is provided forward of the above described light path for the purpose of dividing the parallel flux from the collimating lens 2 into three beams. The above described three beams pass through a beam splitter comprising a polarization beam splitter 4 and a phase plate 5 having a deviation by a predetermined wavelength from the 1/4 wavelength and are reflected from a rotating mirror 6 to be transferred through an objective lens 7 to reach a recording disc 8. The beams passing through the objective lens 7 form three light spots on the surface of the recording disc 8.

Although not shown, minor uneveneses called pits are formed on the surface of the recording disc 8 to store information in the form of these pits. The recording disc 8 is rotated at a high speed. The light beams applied to the recording disc 8 are reflected therefrom upon undergoing intensity modulation as a function of the presence or absence of the pits and are brought to reenter the objective lens 7.

The light beams reflected from the recording disc 8 travel along the light path in the reverse direction to pass through the objective lens 7 and to be reflected from the rotating mirror 6 and further to pass through the phase plate 5 and then are reflected from the polarization beam splitter 4, whereby the direction is changed by 90° so that the light beams are separated from the forward light path. Thereafter the light beams travel in succession through a convex lens 9 and a cylindrical lens 10 to reach a a phto-detector 11. The photodetector 11 comprises a sensitive region group I disposed at the center and divided into four sensitive regions, and two sensitive regions II and III disposed at both sides of the sensitive region group I, totaling six divided sensitive regions constituting the above described photosensor.

The three beams reflected from the recording disc 8 are adapted to impinge upon the sensitive region group I and the sensitive regions II and III. More specifically, the reflected beam corresponding to the center spot out of the three condensed spots on the recording disc 8 is adapted to impinge upon the sensitive region group I, whereby a radio frequency signal (hereinafter referred to as an RF signal) and a focus signal are obtained. The RF signal is a signal representing information recorded on the recording disc 8, while the focus signal is a signal for use in control of a focus actuator, not shown, for moving in the forward and downward direction the objective lens 7 so that the condensed spot may not be defocused on the disc 8 with respect to a plane displacement of the recording disc 8. The remaining two of the three condensed spots on the recording disc 8 are adapted to impinge upon the sensitive regions II and III, respectively, so that a tracking signal may be obtained from these sensitive regions II and III. The tracking signal is used to control the rotating mirror 6 so as to move the condensed spots in the radial direction of the recording disc 8 in order that the condensed spot may always follow the track on the recording disc 8 against eccentricity of the recording disc 8.

Since the inventive apparatus is thus structured, the information recorded on the recording disc 8 can be optically reproduced by the light beam from the semiconductor laser 1.

As is different from a 1/4 wavelength phase plate, the above described phase plate 5 is adapted to have a phase deviation by a predetermined amount from the 1/4 wavelength ($\lambda/4$: $\lambda$ is the wavelength) for the purpose of feeding back a predetermined amount of the reflected light beam from the recording disc 8 to the semiconductor laser 1. More specifically, generally a 1/4 wavelength phase plate is implemented by a plate of artificial crystal and of approximately 1 mm in thickness and adapted such that at least one of the longitudinal and transversal components of the transmitting light beam is delayed in phase by a 1/4 wavelength. Conventionally the apparatus was adapted such that a 1/4 wavelength phase plate is disposed so that the reference axis thereof may be inclined by 45° with respect to the vibration direction of the laser beam emitted from the semiconductor laser 1 of a single longitudinal mode characteristic and the linearly polarized light beam emitted from the semiconductor laser 1 is converted into a circularly polarized beam by means of the 1/4 wavelength phase plate, while the reflected beam from the recording disc 8 is converted into a polarized light beam of lenear polarization intersecting at the right angle the linear polarization of the incident beam by means of the 1/4 wavelength phase plate. By contrast, the embodiment of the present invention employs a phase plate 5 made of the same material as that of the above described 1/4 wavelength phase plate but of a larger (or smaller) thickness, so that the phase amount has a deviation of a predetermined amount from the 1/4 wavelength. The phase plate 5 serves to convert the linearly polarized beam from the semiconductor laser 1 to an elliptically polarized beam and to convert the reflected beam from the recording disc 8 into an elliptically polarized light beam (having a component of the same direction as that of the linear polarization of the incident beam) intersecting at the right angle the linear polarization of the incident beam, whereupon a predetermined amount of the reflected light beam is fed back to the semiconductor laser.

More specifically, in case where the amount of the light beam fed back to the semiconductor laser 1 is to be selected to be 5 % of the amount of the reflected light beam, the phase plate 5 is employed, the thickness of which is adjusted to be a $0.21\lambda$ or $0.29\lambda$ phase plate to involve a $0.04\lambda$ deviation from the 1/4 wavelength ($\lambda/4$, i.e. $0.25\lambda$); in case where 15 % of the amount of the reflected light beam is to be fed back, the phase plate 5 is adjusted to be a $0.19\lambda$ or $0.31\lambda$ phase plate to have a $0.06\lambda$ deviation; and so on.

The reason why a signal to noise ratio is thus improved by feeding back a portion of the reflected light beam exceeding a predetermined amount to a semiconductor laser of a single longitudinal mode will be described in the following. More specifically, it has been observed that a semiconductor laser of a single longitudinal mode exhibits a characteristic in which when the amount of the fed back light beam exceeds a predetermined amount, a semiconductor laser of a single longitudinal mode exhibits a change from the single longitudinal mode to a multiple mode. When the semiconductor laser becomes of a multiple mode, it follows that equivalently the spectrum width of the laser beam is expanded and this results in a much less interference in the semiconductor laser and decreased generation of a noise. Since this approach makes it possible to improve a signal to noise ratio of a reproduced signal by simply changing a design of the phase plate 5 without any necessity at all of changing any other components and arrangements in a conventional apparatus, the above described approach is extremely practical.

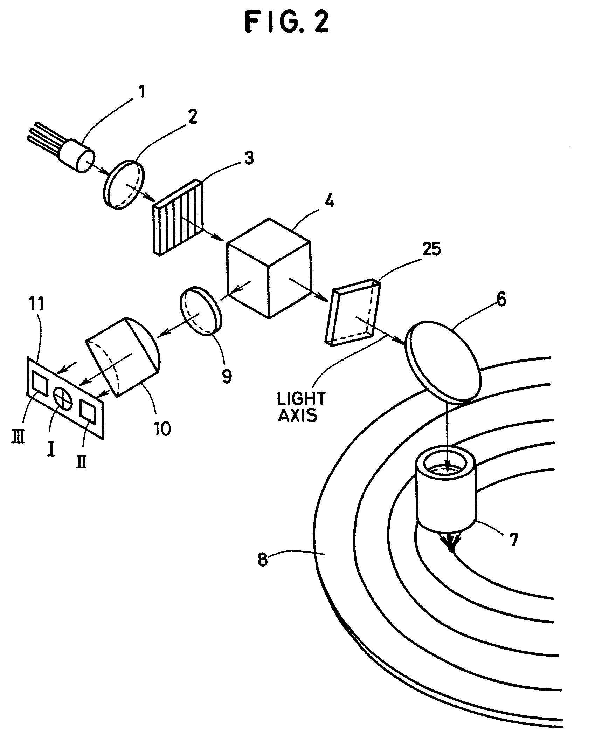

Although in the above described embodiment the light beam was fed back to the semiconductor laser 1 by selecting the phase plate 25 to involve a phase deviation from the 1/4 wavelength, the light beam can be fed back to the semiconductor laser 1 and a signal to noise ratio can be similarly improved by keeping the phase plate to be of the 1/4 wavelength and by disposing the same with the same rotated about the light axis by a predetermined angle. Another embodiment of the present invention employing such implementation for improvement will be described with reference to Fig. 2. The embodiment shown in Fig. 2 is different from the previously described embodiment only in that the phase plate 25 is a 1/4 wavelength phase plate, while all of the remaining portions are the same. More specifically, the phase plate 25 of the embodiment shown in Fig. 2 is implemented as a phase plate of the 1/4 wavelength and the same is disposed to be further inclined by a predetermined angle about the light axis from the semiconductor laser 1 from the angle (the angle for conversion of linear polarization to circular polarization) set with respect to a vibration direction of linear polarization of
the light beam from the semiconductor laser 1 serving as a
light source.

More specifically, by employing the phase plate 25 of
the 1/4 wavelength with the same inclined, in substance the
same function as that of the phase plate involving a wavelength deviation from the 1/4 wavelength is performed as a
consequence and the incident light beam of linear polarization
from the semiconductor laser 1 undergoes elliptical polariza-
tion by the above described inclined 1/4 wavelength phase
plate 25 and the reflected light beam of elliptical polariza-
tion does not turn completely to a linearly polarized light
beam, with the result that the same component as that of the
incident beam is contained as a consequence. Accordingly,
the same component as that of the incident light beam out of
the reflected light beams of the elliptical polarization by
the above described 1/4 wavelength phase plate 25, as obliquely
disposed, is transmitted through the polarization beam
splitter 4 to be fed back to the semiconductor laser 1. The
inclination angle in the case where the inclined 1/4 wavelength phase plate 25 is employed may be selected as described
in the following. In order that 5 % of the reflected light
beam may be fed back the 1/4 wavelength phase plate 25 is
disposed so as to be further inclined by approximately 7°
from the angle used for the linearly polarized light beam from the semiconductor laser 1. In order that 15 % of the reflected light beam may be fed back, likewise the 1/4 wavelength phase plate 25 is disposed so as to be further inclined by approximately 11° from the angle used for the linearly polarized light beam from the semiconductor laser 1. The term "angle used" referred to above means an angle used for converting the linearly polarized light beam from the semiconductor laser 1 to a circularly polarized light beam and, generally, if and when a phase plate is used such that the reference angle may be 45° with respect to the polarization direction of linear polarization, a linearly polarized light beam is converted into a circularly polarized light beam and an incident circularly polarized light beam is converted into a linearly polarized light beam.

In the foregoing the two embodiments were described, one employing a change of the thickness of the phase plate and the other employing a change of the angle used of the phase plate, for the purpose of changing the phase amount of the phase plate. However, it was observed that the phase amount can also be changed by providing an additional phase plate. It was further observed that the phase amount can also be changed by disposing the phase plate involving a wavelength deviation from the 1/4 wavelength so as to be further inclined from the above descirbed angle used.

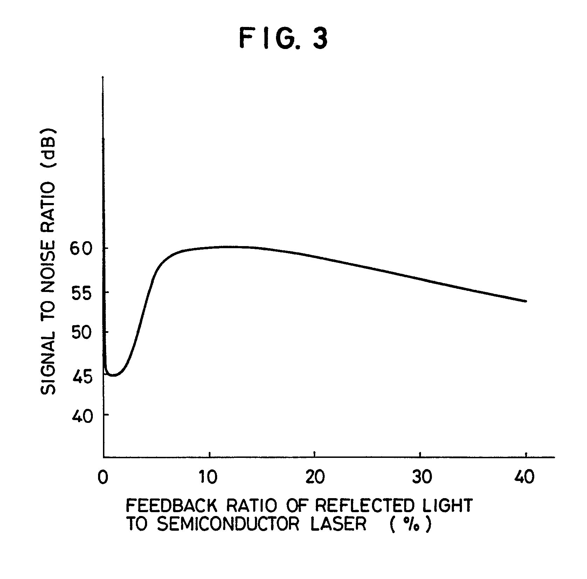

Fig. 3 is a graph showing the data for experimentally confirming the effect of the apparatus in accordance with the embodiment of the present invention. More specifically, Fig. 3 shows the values actually measured in the case where the laser output at the output side of the objective lens in the embodiment shown in Fig. 2 is approximately 0.5 mW. Although theoretically a signal to noise ratio becomes maximum in the case where the feed back amount is 0 %, even a slight amount of feedback abruptly degrades a signal to noise ratio. An improvement starts from the feedback amount of approximately 3 % and a considerable degree of improvement is seen when the feed amount is 5 %. The improvement becomes best when the feedback amount is approximately 15 %, while a stable effect is attained for the feedback amount of 0 to 20 %. When the feedback ratio to the semiconductor laser 1 exceeds 20 % and reaches 40 %, the amount of the light beam impinging upon the photodetector 11 decreases and consequently a signal to noise ratio slightly decreases.

Although the range of the feedback ratio effective for improvement of a signal to noise ratio is considered to be 5 % to 30 %, the laser power actually fed back to the semiconductor laser measured at that time was 5 $\mu$W to 48 $\mu$W.

Although the present invention has been described and illustrated in detail, it is clearly understood that the same is by way of illustration and example only and is not to be taken by way of limitation, the spirit and scope of the present invention being limited only by the terms of the appended claims.

CLAIMS:

1.   Optical information reproducing apparatus
comprising:

a light source (1),

means (6,7) for directing light from the
source to a recording medium and for receiving
light reflected from the recording medium,

means (4,5,25) for separating reflected light
from the light transmitted from the light source,
and

means (11) responsive to the reflected light
which is separated for generating an output signal,

characterised in that the separating means
are adapted to feed back to the light source a or
at least a predetermined quantity of the reflected
light.

2.   Optical information reproducing apparatus,
comprising:

- 2 -

a light source (1) including a semiconductor laser of a longitudinal single mode characteristic,

a condensing lens (7) for condensing and directing a laser beam from said light source to a recording disc (8) having an information track structured to be capable of optical reading and for condensing a light beam reflected from said recording disc,

means (4,5,25) for separating said reflected light beam condensed by said lens from the light path of said laser beam transmitted from said light source to said lens, and

a photodetector (11) for detecting said reflected light beam separated by said separating and feeding back means for providing a reproduced signal,

characterised in that said separating means are adapted for feeding back a portion of said reflected light beam exceeding a predetermined amount to said light source.

- 3 -

3.    Apparatus in accordance with Claim 1 or 2, characterised in that

said separating and feeding back means is adapted to feedback said reflected light beam to said light source at a feedback ratio of 3% to 40%.

4.    Apparatus in accordance with claim 1, 2 or 3, characterised in that

said separating and feeding back means is adapted to feed back said reflected light beam to said light source at a feedback ratio of 15%.

5.    Apparatus in accordance with any preceding claim, characterised in that

said separating and feeding back means comprises in combination

a polarization beam splitter (4), and

a phase plate (5) involving a wavelength deviation by a predetermined amount from the 1/4 wavelength for feeding back a predetermined amount of said reflected light beam to said light source.

6. Apparatus in accordance with claim 5, characterised in that

said phase plate comprises a 0.19 wavelength phase plate.

7. Apparatus in accordance with claim 5, characterised in that

said phase plate comprises a 0.31 wavelength phase plate.

8. Apparatus in accordance with any of claims 1 to 4, characterised in that

said separating and feeding back means comprises in combination

a polarization beam splitter (4), and

a 1/4 wavelength phase plate (25) disposed to be inclined by more than a predetermined angle

- 5 -

about the light axis of said light source with respect to a linearly polarized light beam from said light source for feeding back a predetermined amount of said reflected light beam to said light source.

9. Apparatus in accordance with claim 8, characterised in that

said 1/4 wavelength phase plate is disposed to be inclined at the angle of (45 ± 11)°.

10. Apparatus in accordance with any of claims 1 to 4, characterised in that

said separating and feeding back means comprises in combination

a polarization beam splitter, and

a phase plate involving a phase deviation by a predetermined amount from the 1/4 wavelength and disposed to be inclined at more than a predetermined angle about the light axis of said light source with respect to a lenearly polarized

0109194

- 6 -

light beam from said light source.

11. Apparatus in accordance with any of claims 1 to 4, characterised in that

said separating and feeding back means comprises in combination

a polarization beam splitter,

1/4 wavelength phase plate, and

an additional phase plate of a predetermined wavelength.

# FIG. 1

LIGHT
AXIS

# FIG. 2

LIGHT
AXIS

FIG. 3

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | DE-A-3 027 318 (HITACHI) <br> * Page 3, line 7 - page 5, line 22; page 14, lines 7-32; figure 6 * | 1 | G 11 B 7/12 <br> H 01 S 3/13 |
| | --- | | |
| D,A | Patent Abstracts of Japan vol. 6, no. 233, 19 November 1982 & JP-A-57-133531 (Cat. A) | 1,2,5 | |
| | --- | | |
| A | Patent Abstracts of Japan vol. 5, no. 115, 24 July 1981 & JP-A-56-54644 | 1,2,8 | |
| | ----- | | |

|  |
|---|
| TECHNICAL FIELDS SEARCHED (Int. Cl. ³) |
| G 11 B 7/00 <br> H 01 S 3/00 |

The present search report has been drawn up for all claims

| Place of search <br> BERLIN | Date of completion of the search <br> 29-12-1983 | Examiner <br> WIBERGH S.R. |
|---|---|---|